# EUROPEAN PATENT APPLICATION

(11) **EP 3 333 863 A1**
(43) Date of publication of application: **13.06.2018**
(21) Application number: 16833096.7
(22) Date of filing: 04.08.2016
(51) Int. Cl.: H01G 9/20

(54) **PHOTOELECTRIC CONVERSION ELEMENT**

(30) Priority: 06.08.2015 JP 2015155565
(71) Applicant: Fujikura Ltd., Tokyo 135-8512 (JP)
(72) Inventor: KATSUMATA, Kenji, Sakura-shi Chiba 285-8550 (JP)
(74) Representative: Hoffmann Eitle
(86) International application number: PCT/JP2016/072898
(87) International publication number: WO 2017/022817

(57) **Abstract**

Disclosed is a photoelectric conversion element having a substrate and a plurality of conductive layers provided on the substrate and arranged with grooves interposed therebetween. This photoelectric conversion element includes at least one photoelectric conversion cell. The photoelectric conversion cell includes one conductive layer of the plurality of conductive layers, a counter substrate facing the conductive layer, and an oxide semiconductor layer provided between the conductive layer and the counter substrate, a conductive film is provided on the substrate along a longitudinal direction of the grooves between the plurality of conductive layers, and cracks having a length of 5 µm or more exist in the conductive film at a ratio of 15 or more per 100 µm in length along the longitudinal direction of the groove.

## Description

### TECHNICAL FIELD

The present invention relates to a photoelectric conversion element.

### BACKGROUND ART

As a photoelectric conversion element, a photoelectric conversion element using a dye has attracted attention since it is inexpensive and can obtain high photoelectric conversion efficiency, and various developments have been conducted on photoelectric conversion elements using dyes.

A photoelectric conversion element using a dye includes at least one photoelectric conversion cell and the photoelectric conversion cell generally includes a conductive substrate provided with a conductive layer on a substrate, a counter substrate opposed to the conductive layer, and an oxide semiconductor layer provided between the conductive layer and the counter substrate (refer to, for example, the following Patent Document 1).

### CITATION LIST

### PATENT DOCUMENT

Patent Document 1: JP 2014-192008 A

### SUMMARY OF THE INVENTION

### PROBLEM TO BE SOLVED BY THE INVENTION

However, the photoelectric conversion element described in Patent Document 1 described above still has room for improvement in terms of photoelectric conversion characteristics.

The invention has been achieved in view of the above circumstance and an object thereof is to provide a photoelectric conversion element capable of sufficiently improving photoelectric conversion characteristics.

### MEANS FOR SOLVING PROBLEM

In order to solve the above problems, the present inventors have studied the photoelectric conversion element described in the above-mentioned Patent Document 1. As a result, it was found that, when a resistance value between conductive layers of two adjacent photoelectric conversion cells included in the photoelectric conversion element was measured, and the resistance value was relatively small. The present inventors considered from this fact that the conductive film made of a conductive material remains on the bottom of the groove between the conductive layers of two adjacent photoelectric conversion cells, that is, along the longitudinal direction of the groove and that the conductive film made of the remaining conductive material reduced the resistance value between the conductive layers of the two adjacent photoelectric conversion cells. Therefore, as a result of repetition of intensive studies, the present inventors have found that, at a bottom of the groove between conductive layers of the two adjacent photoelectric conversion cells, that is, in the conductive film provided on the substrate along the longitudinal direction of the groove, there is a correlation between the number of cracks having a length equal to or longer than a specific value observed per specific length along the longitudinal direction of the groove and the photoelectric conversion characteristics, and the above-mentioned problems can be solved by the following invention.

Namely, the invention is a photoelectric conversion element having a substrate; and a plurality of conductive layers provided on the substrate and arranged with grooves interposed therebetween, including at least one photoelectric conversion cell, in which the photoelectric conversion cell includes: one conductive layer of the plurality of conductive layers; a counter substrate facing the conductive layer; and an oxide semiconductor layer provided between the conductive layer and the counter substrate, and in which a conductive film is provided on the substrate along a longitudinal direction of the grooves between the plurality of conductive layers, and cracks having a length of 5 µm or more exist in the conductive film at a ratio of 15 or more per 100 µm in length along the longitudinal direction of the groove.

According to the photoelectric conversion element of the invention, at the bottom of the grooves between the plurality of conductive layers, that is, in the conductive film provided on the substrate along the longitudinal direction of the groove, the cracks having a length of 5 µm or more exist at a ratio of 15 or more per 100 µm in length along the longitudinal direction of the groove. Therefore, since the conductive path in the conductive film is sufficiently cut by the cracks, the insulation between the conductive layers can be sufficiently secured. As a result, it is possible to improve the photoelectric conversion characteristics of the photoelectric conversion element.

In the photoelectric conversion element, it is preferable that the conductive film be made of the same material as the conductive layer.

In the photoelectric conversion element, it is preferable that the cracks having a length of 5 µm or more exist in the conductive film at a ratio of 200 or less per 100 µm in length along the longitudinal direction of the groove.

In this case, the transparency of the groove becomes high as compared with a case where the cracks exist at a ratio of more than 200 per 100 µm in length along the longitudinal direction of the groove.

In the photoelectric conversion element, it is particularly preferable that the cracks having a length of 5 µm or more exist in the conductive film at a ratio of 40 or less per 100 µm in length along the longitudinal direction of the groove.

In the above photoelectric conversion element, it is preferable that cracks having a length of 5 µm or more exist in the conductive film at a ratio of 34 or more per 100 µm in length along the longitudinal direction of the groove in the conductive film.

In this case, it is possible to further improve the photoelectric conversion characteristics of the photoelectric conversion element.

In the photoelectric conversion element, it is preferable that cracks intersecting each other exist in the conductive film.

In this case, due to the presence of cracks that intersect each other in the conductive film, it is possible to cut the conductive path in the conductive film over a longer distance. For this reason, it is possible to more sufficiently improve the photoelectric conversion characteristics of the photoelectric conversion element.

In the photoelectric conversion element, it is preferable that the grooves between the plurality of conductive layers be covered with an insulating material.

In this case, since the insulating material enters the cracks, the insulation between the conductive layers can be more sufficiently secured.

In the photoelectric conversion element, it is preferable that a maximum thickness of the conductive film is 150 nm or less, a width of the groove is 200 nm or less, and a bottom of the cracks reaches an interface between the substrate and the conductive film.

In this case, since the conductive path in the conductive film is effectively cut by the cracks, the insulation between the conductive layers can be effectively secured. As a result, it is possible to effectively improve the photoelectric conversion characteristics of the photoelectric conversion element.

In the photoelectric conversion element, it is preferable that the bottom of the cracks reaches a position farther from the conductive film than the interface between the substrate and the conductive film in the substrate.

In this case, since the conductive path is cut more reliably in the length direction of the cracks, the resistance of the conductive film can be further increased.

In the photoelectric conversion element, it is preferable that the cracks be in contact with the conductive layer.

In this case, the insulation between the adjacent conductive layers is further improved as compared with a case where the cracks are not in contact with the conductive layer.

In the invention, the "conductive film" denotes a layer having a maximum thickness smaller than that of the conductive layer.

In the invention, the number of "cracks" denotes an average value of the number of cracks observed in case of observing 10 regions having a length of 100 µm along the longitudinal direction of the grooves between the plurality of conductive layers by using a scanning electron microscope (SEM). Whether or not the observed line is a crack can be determined by whether or not the width of the line is in a range of 0.1 to 2 µm and the line is a line of lower lightness or a line of higher lightness than its surroundings.

Furthermore, in the invention, "the maximum thickness of the conductive film" denotes an average value of the maximum thickness of the conductive film observed in each region in case of observing the 10 regions having a length of 100 µm along the longitudinal direction of the grooves between the plurality of conductive layers by using a transmission electron microscope (TEM).

### EFFECT OF THE INVENTION

According to the invention, a photoelectric conversion element capable of sufficiently improving photoelectric conversion characteristics is provided.

### BRIEF DESCRIPTION OF DRAWINGS

Fig. 1 is an end view of the cut surface illustrating a photoelectric conversion element according to a first embodiment of the invention;
Fig. 2 is a plan view illustrating a portion of the photoelectric conversion element according to the first embodiment of the invention;
Fig. 3 is a plan view illustrating a pattern of transparent conductive layers in the photoelectric conversion element in Fig. 1;
Fig. 4 is a partial plan view illustrating a bottom of a groove between adjacent transparent conductive layers in Fig. 3;
Fig. 5 is a partial end view of the cut surface taken along line V-V in Fig. 4;
Fig. 6 is a plan view illustrating a first integrated sealing portion in Fig. 1;
Fig. 7 is a plan view illustrating a second integrated sealing portion in Fig. 1;
Fig. 8 is a partial end view of the cut surface taken along line VIII-VIII in Fig. 2;
Fig. 9 is a plan view illustrating a conductive substrate where an insulating material, a connecting portion for fixing a back sheet, and an oxide semiconductor layer are formed;
Fig. 10 is a plan view illustrating a first integrated sealing portion forming body for forming the first integrated sealing portion in Fig. 6; and
Fig. 11 is a partial end view of the cut surface illustrating a photoelectric conversion element according to a second embodiment of the invention.

### MODE(S) FOR CARRYING OUT THE INVENTION

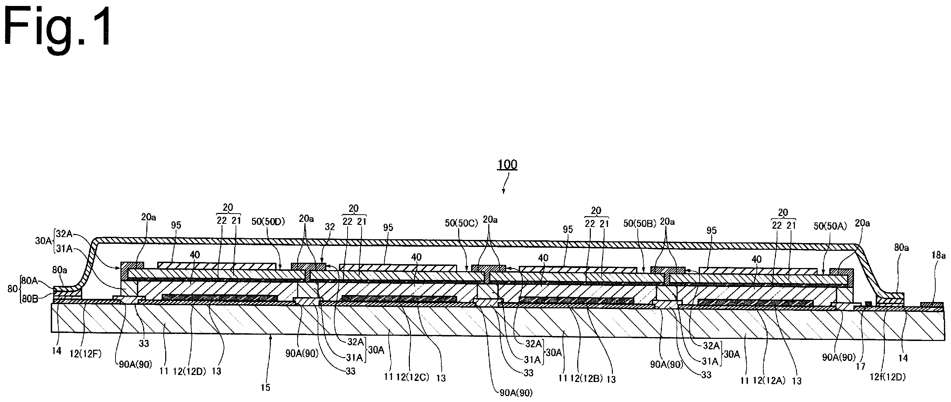

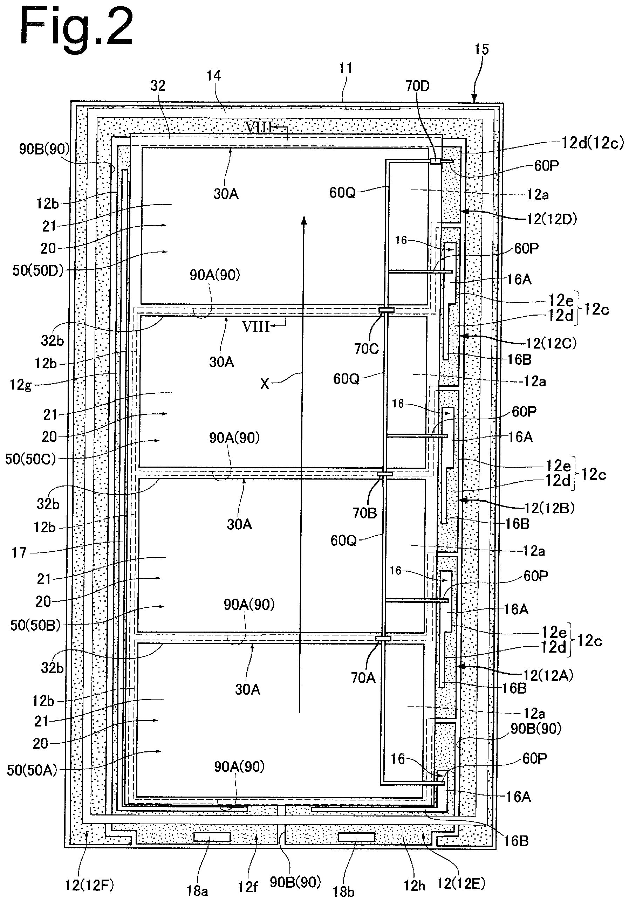

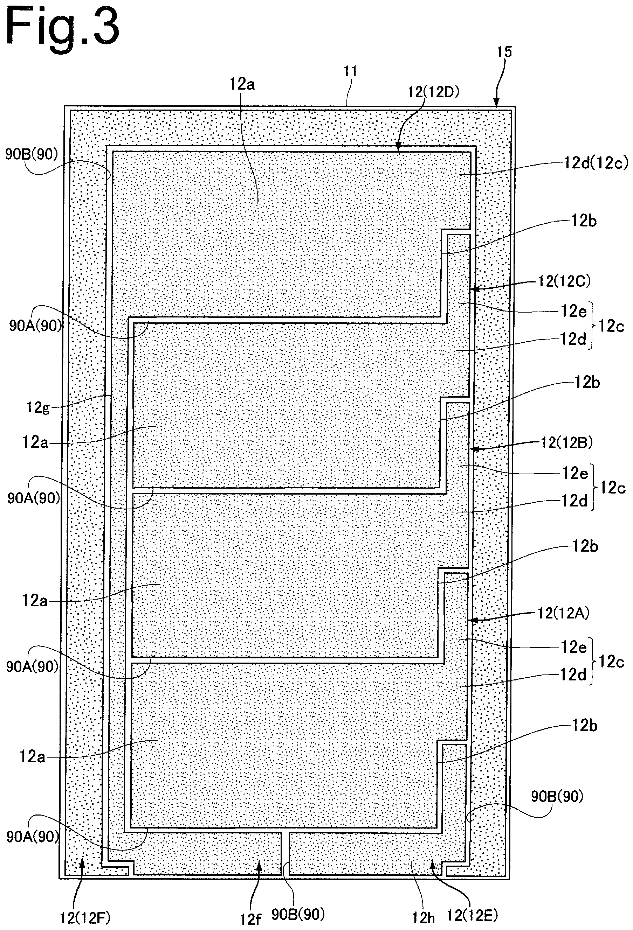

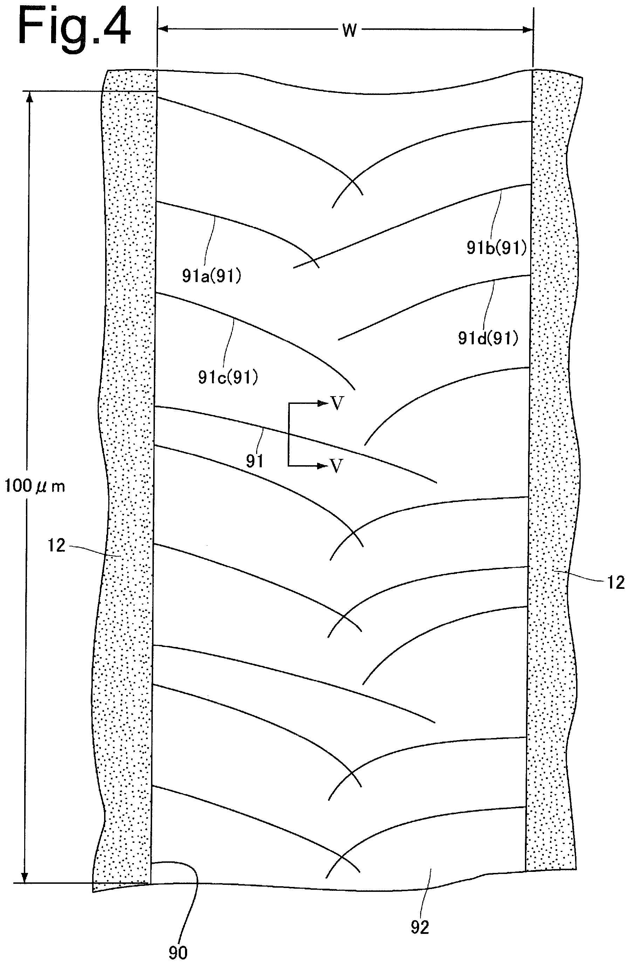

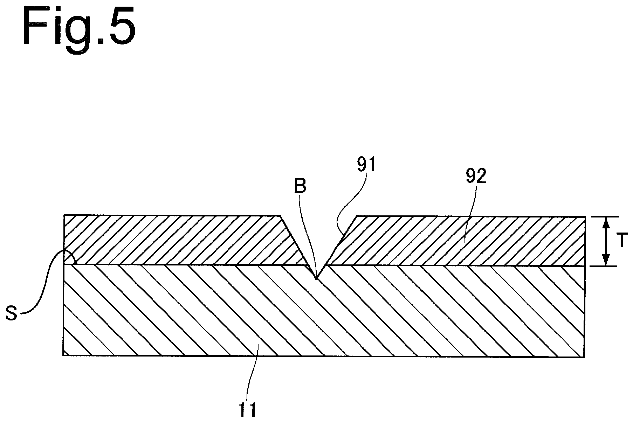

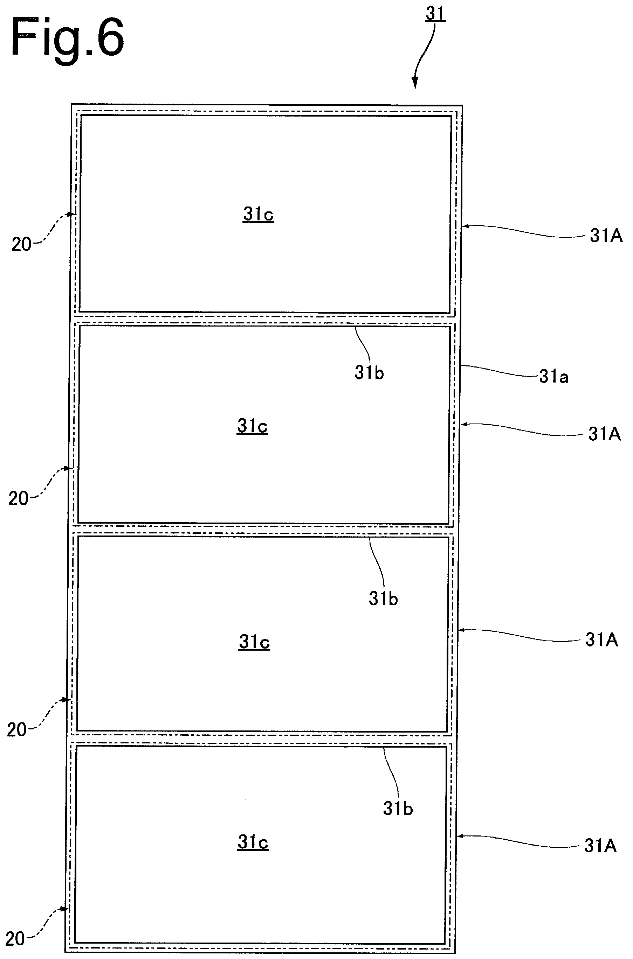

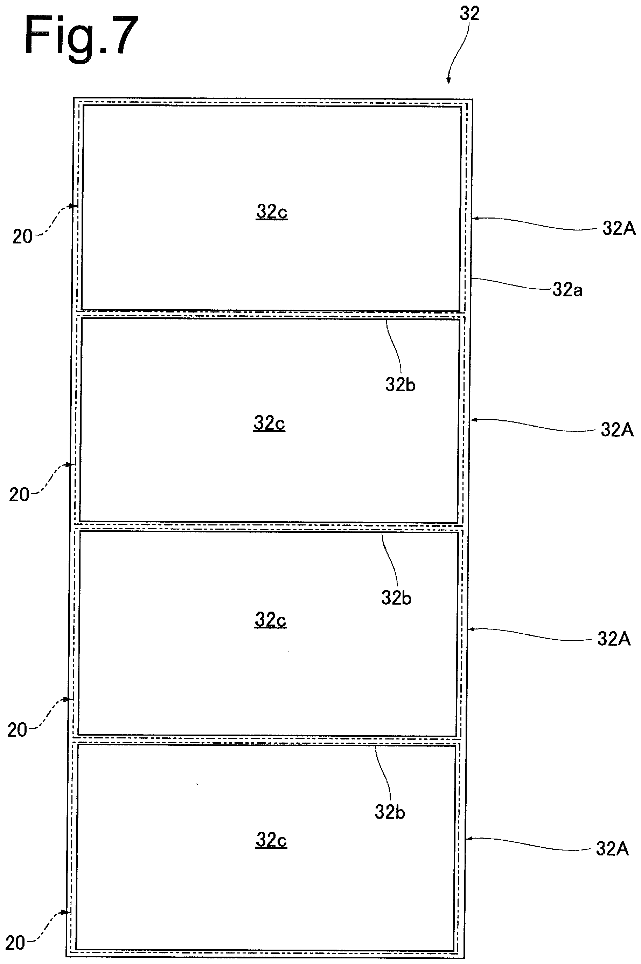

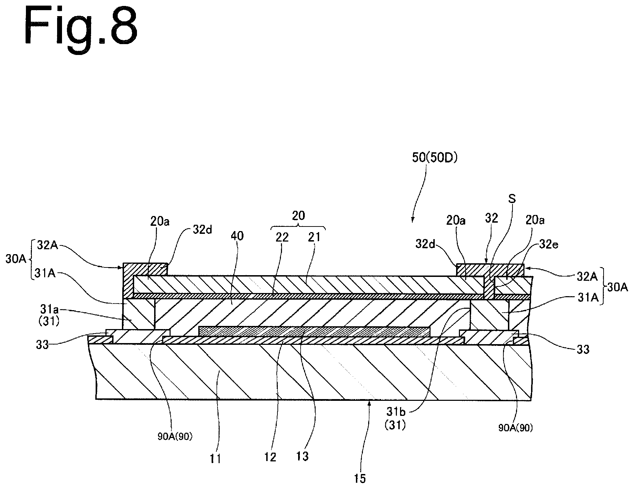

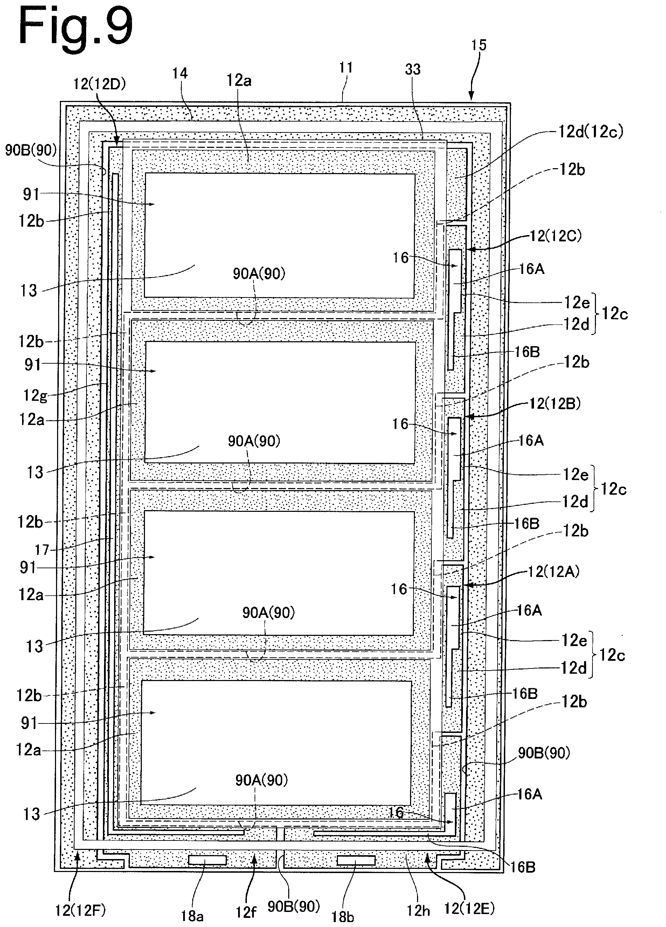

Hereinafter, preferred embodiments of a photoelectric conversion element according to the invention will be described in detail with reference to Figs. 1 to 9. Fig. 1 is an end view of the cut surface illustrating a photoelectric conversion element according to a preferred embodiment of the invention. Fig. 2 is a plan view illustrating a portion of the photoelectric conversion element according to the preferred embodiment of the invention. Fig. 3 is a plan view illustrating a pattern of transparent conductive layers in the photoelectric conversion element of Fig. 1. Fig. 4 is a partial plan view illustrating a bottom of a groove between adjacent transparent conductive layers in Fig. 3. Fig. 5 is a partial end view of the cut surface taken along line V-V in Fig. 4. Fig. 6 is a plan view illustrating a first integrated sealing portion in Fig. 1. Fig. 7 is a plan view illustrating a second integrated sealing portion in Fig. 1. Fig. 8 is a partial end view of the cut surface taken along line VIII-VIII in Fig. 2. Fig. 9 is a plan view illustrating a conductive substrate where an insulating material, a connecting portion for fixing a back sheet, and an oxide semiconductor layer are formed.

As illustrated in Fig. 1, the photoelectric conversion element 100 includes a conductive substrate 15 provided with a transparent substrate 11 and a plurality of transparent conductive layers 12 which are arranged on the transparent substrate 11 with grooves 90 interposed therebetween.

The photoelectric conversion element 100 includes one transparent substrate 11 and a plurality (four in the embodiment) of photoelectric conversion cells 50 formed on the transparent substrate 11. Hereinafter, for the convenience of description, the plurality of photoelectric conversion cells 50 will be referred to as photoelectric conversion cells 50A to 50D as necessary. The photoelectric conversion cell 50 includes one transparent conductive layer 12 of the plurality of transparent conductive layers 12, a counter substrate 20 facing the transparent conductive layer 12, and an oxide semiconductor layer 13 provided between the transparent conductive layer 12 and the counter substrate 20. In this embodiment, the oxide semiconductor layer 13 is provided on the transparent conductive layer 12. The conductive substrate 15 and the counter substrate 20 are joined by an annular sealing portion 30A, and the cell space formed by the conductive substrate 15, the counter substrate 20, and the annular sealing portion 30A is filled with the electrolyte 40. The oxide semiconductor layer 13 is arranged inside the annular sealing portion 30A, and the oxide semiconductor layer 13 carries a dye. As illustrated in Fig. 2, the plurality of photoelectric conversion cells 50 are connected in series by conductive materials 60P. In addition, a back sheet 80 is provided on the side of the photoelectric conversion cell 50 facing the counter substrate 20 (refer to Fig. 1).

The counter substrate 20 is constituted by a counter electrode and includes a metal substrate 21 as an electrode and a catalyst layer 22 provided on the side of the metal substrate 21 facing the conductive substrate 15 to facilitate a catalytic reaction. In addition, in the two adjacent photoelectric conversion cells 50, the counter substrates 20 are separated from each other.

As illustrated in Fig. 3, the conductive substrate 15 has a transparent substrate 11 and a plurality of transparent conductive layers 12A to 12F as electrodes which are arranged on the transparent substrate 11 with the grooves 90 interposed therebetween. Among the plurality of transparent conductive layers 12A to 12F, the transparent conductive layers 12A to 12D are transparent conductive layers 12 constituting the electrodes of the photoelectric conversion cells 50A to 50D. The transparent conductive layers 12E and 12F are the transparent conductive layers 12 which do not constitute the electrodes of the photoelectric conversion cells 50A to 50D. The transparent conductive layers 12E and 12F are provided around the transparent conductive layers 12A to 12D. The transparent conductive layer 12E is arranged so as to be bent along the sealing portion 30A. The transparent conductive layer 12F is an annular transparent conductive layer 12 for fixing the peripheral portion 80a of the back sheet 80 (refer to Fig. 1) .

As illustrated in Fig. 3, all of the transparent conductive layers 12A to 12D have a quadrangular-shaped main body portion 12a having a side edge portion 12b and a protruding portion 12c which laterally protrudes from the side edge portion 12b of the main body portion 12a.

As illustrated in Fig. 2, the protruding portion 12c of the transparent conductive layer 12C of the photoelectric conversion cell 50C among the transparent conductive layers 12A to 12D has a projecting portion 12d which laterally projects with respect to the arrangement direction X of the photoelectric conversion cells 50A to 50D and a facing portion 12e which extends from the projecting portion 12d and faces the main body portion 12a of the adjacent photoelectric conversion cell 50D via the groove 90.

In the photoelectric conversion cell 50B as well, the protruding portion 12c of the transparent conductive layer 12B has the projecting portion 12d and the facing portion 12e. In addition, in the photoelectric conversion cell 50A as well, the protruding portion 12c of the transparent conductive layer 12A has the projecting portion 12d and the facing portion 12e.

Meanwhile, the photoelectric conversion cell 50D is connected with the photoelectric conversion cell 50C already and there is no other photoelectric conversion cell 50 to be connected. For this reason, in the photoelectric conversion cell 50D, the protruding portion 12c of the transparent conductive layer 12D does not have a facing portion 12e. In other words, the protruding portion 12c of the transparent conductive layer 12D is constituted by only the projecting portion 12d.

However, the transparent conductive layer 12D further has a first current extracting portion 12f for extracting the current generated in the photoelectric conversion element 100 to the outside and a connecting portion 12g which connects the first current extracting portion 12f and the main body portion 12a and extends along the side edge portion 12b of the transparent conductive layers 12A to 12C. The first current extracting portion 12f is disposed in the vicinity of the photoelectric conversion cell 50A and on the side opposite to the transparent conductive layer 12B with respect to the transparent conductive layer 12A.

On the other hand, the transparent conductive layer 12E also includes a second current extracting portion 12h for extracting the current generated by the photoelectric conversion element 100 to the outside, and the second current extracting portion 12h is arranged in the vicinity of the photoelectric conversion cell 50A and on the side opposite to the transparent conductive layer 12B with respect to the transparent conductive layer 12A. The first current extracting portion 12f and the second current extracting portion 12h are arranged to be adjacent to each other via the groove 90B (90) in the periphery of the photoelectric conversion cell 50A.

Herein, the groove 90 is configured by a first groove 90A which is formed along an edge portion of the main body portion 12a of the transparent conductive layer 12 and a second groove 90B which is formed along an edge portion of a portion of the transparent conductive layer 12 excluding the main body portion 12a and intersects the peripheral edge portion 80a of the back sheet 80.

As illustrated in Fig. 4, at the bottom of the groove 90 between the adjacent transparent conductive layers 12, that is, in the conductive film 92 provided on the transparent substrate 11 along the longitudinal direction of the groove 90, the cracks 91 extend from each of the edges on both sides of the groove 90 toward the edge on the opposite side of the groove 90. Herein, the cracks 91 are in contact with the edge of the groove 90, that is, the transparent conductive layer 12. The cracks 91 having a length of 5 µm or more exist in the conductive film 92 at a ratio of 15 or more per 100 µm in length along the longitudinal direction of the groove 90. In addition, at the bottom of the groove 90 between the adjacent transparent conductive layers 12, that is, in the conductive film 92 provided on the transparent substrate 11 along the longitudinal direction of the groove 90, cracks 91c and 91d which do not intersect with other cracks 91 and cracks 91a and 91b which intersect with other cracks 91 exist. Meanwhile, in Fig. 4, the edge of the groove 90 is straight, but the edge of the groove may not be straight.

As illustrated in Fig.2, the connecting terminals 16 are provided on each of the protruding portions 12c of the transparent conductive layers 12A to 12C and the transparent conductive layer 12E. Each connecting terminal 16 has a conductive material connecting portion 16A which is connected to the conductive material 60P and extends along the sealing portion 30A outside the sealing portion 30A and a conductive material non-connecting portion 16B which extends from the conductive material connecting portion 16A along the sealing portion 30A outside the sealing portion 30A. In the embodiment, in the transparent conductive layers 12A to 12C, at least the conductive material connecting portion 16A of the connecting terminal 16 is provided on the counter portion 12e of the protruding portion 12c and faces the main body portion 12a of the connected adjacent photoelectric conversion cell 50. In the transparent conductive layer 12E, the conductive material connecting portion 16A of the connecting terminal 16 faces the main body portion 12a of the connected adjacent photoelectric conversion cell 50A.

The conductive material connecting portion 16A of the connecting terminal 16 provided on the protruding portion 12c of the transparent conductive layer 12C in the photoelectric conversion cell 50C is connected to the metal substrate 21 of the counter substrate 20 in the adjacent photoelectric conversion cell 50D through the conductive material 60P. The conductive material 60P is arranged so as to pass on the sealing portion 30A. Similarly, the conductive material connecting portion 16A of the connecting terminal 16 in the photoelectric conversion cell 50B is connected to the metal substrate 21 of the counter substrate 20 in the adjacent photoelectric conversion cell 50C through the conductive material 60P, the conductive material connecting portion 16A of the connecting terminal 16 in the photoelectric conversion cell 50A is connected to the metal substrate 21 of the counter substrate 20 in the adjacent photoelectric conversion cell 50B through the conductive material 60P, and the conductive material connecting portion 16A of the connecting terminal 16 on the transparent conductive layer 12E is connected to the metal substrate 21 of the counter substrate 20 in the adjacent photoelectric conversion cell 50A through the conductive material 60P.

In addition, external connecting terminals 18a and 18b are provided on first and second current extracting portions 12f and 12h, respectively.

As illustrated in Fig. 1, the sealing portion 30A includes an annular first sealing portion 31A which is provided between the conductive substrate 15 and the counter substrate 20 and a second sealing portion 32A provided so as to overlap with the first sealing portion 31A and which interposes an edge portion 20a of the counter substrate 20, together with the first sealing portion 31A. As illustrated in Fig. 6, the first sealing portions 31A adjacent to each other are integrated to constitute a first integrated sealing portion 31. In other words, the first integrated sealing portion 31 is constituted by an annular portion (hereinafter, referred to as an "annular portion") 31a which is not provided between the two counter substrates 20 adjacent to each other and a portion (hereinafter, referred to as a "partitioning portion") 31b which is provided between the two counter substrates 20 adjacent to each other and partitions an inner opening 31c of the annular portion 31a. In addition, as illustrated in Fig. 7, the second sealing portions 32A are integrated between the counter substrates 20 adjacent to each other to constitute a second integrated sealing portion 32. The second integrated sealing portion 32 is constituted by an annular portion (hereinafter, referred to as a "annular portion") 32a which is not provided between the two counter substrates 20 adjacent to each other and a portion (hereinafter, referred to as a "partitioning portion") 32b which is provided between the two counter substrates 20 adjacent to each other and partitions an inner opening 32c of the annular portion 32a.

In addition, as illustrated in Fig. 1, between the first sealing portion 31A and the groove 90, an insulating material 33 is provided so as to enter the groove 90 between the adjacent transparent conductive layers 12A to 12F and extend over the adjacent transparent conductive layers 12. Namely, the portion of the groove 90 along the first sealing portion 31A is covered with the insulating material 33.

In addition, as illustrated in Fig. 8, the second integrated sealing portion 32 includes a main body portion 32d provided on the side of the counter substrate 20 opposite to the conductive substrate 15 and an adhesive portion 32e provided between the adjacent counter substrates 20. The second integrated sealing portion 32 is adhered to the first integrated sealing portion 31 by the adhesive portion 32e.

As illustrated in Fig. 1, a back sheet 80 is provided on the conductive substrate 15. The back sheet 80 includes a stacked body 80A including a weather resistant layer and a metal layer and an adhesive portion 80B provided in the side opposite to the metal layer with respect to the stacked body 80A and adhered to the conductive substrate 15 via a coupling portion 14. Herein, the adhesive portion 80B is used to adhere the back sheet 80 to the conductive substrate 15, and as illustrated in Fig. 1, the adhesive portion may be formed in the peripheral edge portion of the stacked body 80A. However, the adhesive portion 80B may be provided over the entire surface of the side of the stacked body 80A facing the photoelectric conversion cell 50 of the stacked body 80A. The peripheral edge portion 80a of the back sheet 80 is connected to the transparent conductive layers 12D, 12E, and 12F of the transparent conductive layers 12 via the coupling portion 14 by the adhesive portion 80B. Herein, the adhesive portion 80B is separated from the sealing portion 30A of the photoelectric conversion cell 50. In addition, the coupling portion 14 is also separated from the sealing portion 30A.

In addition, as illustrated in Fig. 2, in the transparent conductive layer 12D, a current collecting wiring 17 having a lower resistance than that of the transparent conductive layer 12D extends so as to pass through the main body portion 12a, the connecting portion 12g, and the current extracting portion 12f. This current collecting wiring 17 is disposed so as not to intersect with the coupling portion 14 of the back sheet 80 and the conductive substrate 15. In other words, the current collecting wiring 17 is disposed on the inner side than the coupling portion 14.

Meanwhile, as illustrated in Fig. 2, bypass diodes 70A to 70D are connected in parallel with the photoelectric conversion cells 50A to 50D, respectively. Specifically, the bypass diode 70A is fixed on the partitioning portion 32b of the second integrated sealing portion 32 between the photoelectric conversion cell 50A and the photoelectric conversion cell 50B, the bypass diode 70B is fixed on the partitioning portion 32b of the second integrated sealing portion 32 between the photoelectric conversion cell 50B and the photoelectric conversion cell 50C, and the bypass diode 70C is fixed on the partitioning portion 32b of the second integrated sealing portion 32 between the photoelectric conversion cell 50C and the photoelectric conversion cell 50D. The bypass diode 70D is fixed on the sealing portion 30A of the photoelectric conversion cell 50D. In addition, the conductive material 60Q is fixed to the metal substrate 21 of the counter substrate 20 so as to pass through the bypass diodes 70A to 70D. Moreover, the conductive material 60P branches out from the conductive materials 60Q between the bypass diodes 70A and 70B, between the bypass diodes 70B and 70C, and between the bypass diodes 70C and 70D, respectively, and is connected with the conductive material connecting portion 16A on the transparent conductive layer 12A, the conductive material connecting portion 16A on the transparent conductive layer 12B, and the conductive material connecting portion 16A on the transparent conductive layer 12C, respectively. In addition, the conductive material 60P is also fixed to the metal substrate 21 of the counter substrate 20 of the photoelectric conversion cell 50A, and this conductive material 60P connects the bypass diode 70A and the conductive material connecting portion 16A of the connecting terminal 16 on the transparent conductive layer 12E. Moreover, the bypass diode 70D is connected with the transparent conductive layer 12D via the conductive material 60P.

Meanwhile, a desiccant 95 is provided on the counter substrate 20 of each photoelectric conversion cell 50.

According to the photoelectric conversion element 100, at the bottom of the groove 90 between the plurality of transparent conductive layers 12, that is, in the conductive film 92 provided on the transparent substrate 11 along the longitudinal direction of the groove 90, the cracks 91 having a length of 5 µm or more exist at a ratio of 15 or more per 100 µm in length along the longitudinal direction of the groove 90. For this reason, since the conductive path in the conductive film 92 is sufficiently cut by the cracks 91, the insulation between the transparent conductive layers 12 can be sufficiently secured. As a result, it is possible to improve the photoelectric conversion characteristics of the photoelectric conversion element 100.

In addition, in the photoelectric conversion element 100, in the conductive film 92 between the adjacent transparent conductive layers 12, the cracks 91 are in contact with the edge of the groove 90, that is, the transparent conductive layer 12. Therefore, as compared with a case where the cracks 91 are not in contact with the edge of the groove 90, that is, the transparent conductive layer 12, the insulation between the adjacent transparent conductive layers 12 is further improved.

In addition, in the photoelectric conversion element 100, cracks 91a and 91b that intersect with other cracks 91 exist at the bottom of the groove 90 between the adjacent transparent conductive layers 12. Thus, due to the existence of the cracks 91 intersecting each other, it is possible to cut the conductive path at the bottom of the groove 90 between the adjacent transparent conductive layers 12 over a longer distance. For this reason, it is possible to more sufficiently improve the photoelectric conversion characteristic of the photoelectric conversion element 100.

In addition, in the photoelectric conversion element 100, the portion of the groove 90 along the first sealing portion 31A is covered with the insulating material 33. In this case, since the insulating material enters the cracks 91 existing in the groove 90, the insulation between the transparent conductive layers 12 can be more sufficiently secured.

In the photoelectric conversion element 100, the sealing portion 30A and the insulating material 33 are arranged so as to overlap with each other. For this reason, as compared with a case where the insulating material 33 is arranged so as not to overlap with the sealing portion 30A, it is possible to further increase the area of the portion contributing to power generation as viewed from the light receiving surface side of the photoelectric conversion element 100. Therefore, it is possible to further improve the aperture ratio.

In addition, in the photoelectric conversion element 100, the first current extracting portion 12f and the second current extracting portion 12h are disposed in the vicinity of the photoelectric conversion cell 50A and on the side opposite to the transparent conductive layer 12B with respect to the transparent conductive layer 12A, and the first current extracting portion 12f of the transparent conductive layer 12A and the second current extracting portion 12h of the transparent conductive layer 12F are disposed so as to be adjacent to each other via the groove 90. For this reason, in the photoelectric conversion element 100, it is possible to dispose the external connecting terminals 18a and 18b to the first current extracting portion 12f and the second current extracting portion 12h, respectively, so as to be adjacent to each other. Hence, it is possible to set the number of connectors for extracting the current from the external connecting terminals 18a and 18b to the outside to one. In other words, if the first current extracting portion 12f is disposed on the side opposite to the transparent conductive layer 12C with respect to the transparent conductive layer 12D, the external connecting terminals 18a and 18b are also disposed to be greatly spaced apart from each other since the first current extracting portion 12f and the second current extracting portion 12h are disposed to be greatly spaced apart from each other. In this case, two connectors of a connector to be connected with the external connecting terminal 18a and a connector to be connected with the external connecting terminal 18b are required in order to extract the current from the photoelectric conversion element 100. However, according to the photoelectric conversion element 100, since it is possible to dispose the external connecting terminals 18a and 18b so as to be adjacent to each other, only one connector is required. For this reason, according to the photoelectric conversion element 100, it is possible to achieve space saving. In addition, the generated current is low in the photoelectric conversion element 100 when the photoelectric conversion element 100 is used under a low illuminance. Specifically, the generated current is 2 mA or lower. For this reason, it is possible to sufficiently suppress the deterioration of the photoelectric conversion performance of the photoelectric conversion element 100 even if a part of the transparent conductive layer 12D of the photoelectric conversion cell 50D on one end side of the photoelectric conversion cell 50A and photoelectric conversion cell 50D at both ends of the photoelectric conversion cells 50A to 50D is disposed next to the second current extracting portion 12h which is electrically connected with the metal substrate 21 of the counter substrate 20 of the photoelectric conversion cell 50A on the other end side via the groove 90 as the first current extracting portion 12f.

In addition, in the photoelectric conversion element 100, the photoelectric conversion cells 50A to 50D are arranged in a line along the X direction, the transparent conductive layer 12D of the photoelectric conversion cell 50D on one end side of the photoelectric conversion cell 50A and photoelectric conversion cell 50D at both ends of the photoelectric conversion cells 50A to 50D has the main body portion 12a provided on the inner side of the sealing portion 30A, the first current extracting portion 12f, and the connecting portion 12g which connects the main body portion 12a and the first current extracting portion 12f. For this reason, it is possible to more shorten the installation region of the connecting terminal 16 provided along the arrangement direction (X direction in Fig. 2) of the photoelectric conversion cells 50A to 50D in order to connect two adjacent photoelectric conversion cells 50 compared to a case in which the photoelectric conversion cells 50C and 50D of a part of the photoelectric conversion cells 50A to 50D are folded back in the middle and the photoelectric conversion cell 50A and the photoelectric conversion cell 50D are disposed so as to be adjacent to each other, and thus it is possible to achieve space saving to a greater extent. Furthermore, according to the photoelectric conversion element 100, since the generated current is usually low in a case in which the photoelectric conversion element 100 is used in a low illuminance environment, it is possible to sufficiently suppress the deterioration of the photoelectric conversion characteristics even if the photoelectric conversion element 100 further has the first connecting portion 12g which connects the main body portion 12a and the first current extracting portion 12f.

In addition, in the photoelectric conversion element 100, the current collecting wiring 17 is arranged so as not to intersect the coupling portion 14 between the back sheet 80 and the conductive substrate 15. Since the current collecting wiring 17 is generally porous, the current collecting wiring has gas permeability, and thus, gases such as water vapor are permeable. However, the current collecting wiring 17 is arranged so as not to intersect the coupling portion 14 between the back sheet 80 and the conductive substrate 15. For this reason, the infiltration of water vapor or the like from the outside through the current collecting wiring 17 into the space between the back sheet 80 and the conductive substrate 15 can be prevented. As a result, the photoelectric conversion element 100 can have excellent durability. In addition, since the current collecting wiring 17 has a resistance lower than that of the transparent conductive layer 12D, even when the generated current becomes large, a deterioration in photoelectric conversion characteristics can be sufficiently suppressed.

In addition, the conductive material 60P connected with the metal substrate 21 of the counter substrate 20 of one photoelectric conversion cell 50 of two adjacent photoelectric conversion cells 50 is connected with the conductive material connecting portion 16A on the protruding portion 12c of the other photoelectric conversion cell 50, and the conductive material connecting portion 16A is provided on the protruding portion 12c and on the outer side of the sealing portion 30A. In other words, the connection of two adjacent photoelectric conversion cells 50 is performed on the outer side of the sealing portion 30A. For this reason, according to the photoelectric conversion element 100, it is possible to improve the aperture ratio.

In addition, in the photoelectric conversion element 100, in the photoelectric conversion cell 50 that is connected with the adjacent photoelectric conversion cell 50 among the photoelectric conversion cells 50A to 50D, the protruding portion 12c has the projecting portion 12d which laterally projects from the main body portion 12a and the facing portion 12e which extends from the projecting portion 12d and faces the main body portion 12a of the adjacent photoelectric conversion cell 50, and at least the conductive material connecting portion 16A of the connecting terminal 16 is provided on the facing portion 12e.

In this case, since at least the conductive material connecting portion 16A of the connecting terminal 16 is provided on the facing portion 12e facing the main body portion 12a of the adjacent photoelectric conversion cell 50, it is possible to sufficiently prevent the conductive material 60P connected with the conductive material connecting portion 16A from passing over the metal substrate 21 of the counter substrate 20 of the adjacent photoelectric conversion cell 50 unlike the case in which at least the conductive material connecting portion 16A of the connecting terminal 16 is not provided on the facing portion 12e facing the main body portion 12a of the adjacent photoelectric conversion cell 50. As a result, it is possible to sufficiently prevent the short circuit between the adjacent photoelectric conversion cells 50.

In addition, in the photoelectric conversion element 100, both of the conductive material connecting portion 16A and the conductive material non-connecting portion 16B are disposed along the sealing portion 30A. For this reason, it is possible to save the space required for the connecting terminal 16 compared to the case of disposing the conductive material connecting portion 16A and the conductive material non-connecting portion 16B along the direction away from the sealing portion 30A.

Furthermore, in the photoelectric conversion element 100, the adhesive portion 80B of the back sheet 80 is spaced apart from the sealing portion 30A of the photoelectric conversion cell 50. For this reason, it is sufficiently suppressed that the sealing portion 30A is stretched since the adhesive portion 80B is constricted at a low temperature and thus an excessive stress is applied to the interface between the sealing portion 30A and the conductive substrate 15 or the counter substrate 20. In addition, at a high temperature as well, it is sufficiently suppressed that the sealing portion 30A is pressed since the adhesive portion 80B expands and thus an excessive stress is applied to the interface between the sealing portion 30A and the conductive substrate 15 or the counter substrate 20. In other words, it is sufficiently suppressed that an excessive stress is applied to the interface between the sealing portion 30A and the conductive substrate 15 or the counter substrate 20 both at a high temperature and a low temperature. For this reason, it is possible for the photoelectric conversion element 100 to have excellent durability.

In addition, in the photoelectric conversion element 100, the second sealing portion 32A is adhered to the first sealing portion 31A, and the edge portion 20a of the counter substrate 20 is sandwiched by the first sealing portion 31A and the second sealing portion 32A. For this reason, even when stress is applied to the counter substrate 20 in a direction in which the counter substrate is separated from the conductive substrate 15, its peeling-off is sufficiently suppressed by the second sealing portion 32A. Further, since the partitioning portion 32b of the second integrated sealing portion 32 is adhered to the first sealing portion 31A through the gap S between the adjacent counter substrates 20. For this reason, the counter substrates 20 of the photoelectric conversion cells 50 adjacent to each other are reliably prevented from contacting each other.

Next, the conductive substrate 15, the oxide semiconductor layer 13, the insulating material 33, the coupling portion 14, the dye, the counter substrate 20, the sealing portion 30A, the electrolyte 40, the conductive materials 60P and 60Q, the back sheet 80, and the desiccant 95 will be described in detail.

### (Conductive substrate)

The conductive substrate 15 has the transparent substrate 11 and the plurality of transparent conductive layers 12A to 12F.

The material constituting the transparent substrate 11 may be any transparent material, for example, and examples of such a transparent material include glass such as borosilicate glass, soda lime glass, glass which is made of soda lime and whose iron component is less than that of ordinary soda lime glass, and quartz glass, polyethylene terephthalate (PET), polyethylene naphthalate (PEN), polycarbonate (PC), and polyethersulfone (PES). The thickness of the transparent substrate 11 is appropriately determined depending on the size of the photoelectric conversion element 100 and is not particularly limited, but it may be set into the range of from 50 to 10000 µm, for example.

Examples of the material contained in the transparent conductive layer 12 include a conductive metal oxide such as indium-tin-oxide (ITO), tin oxide (Sn0₂), and fluorine-doped-tin-oxide (FTO). The transparent conductive layer 12 may be constituted by a single layer or a laminate consisting of a plurality of layers containing different conductive metal oxides. It is preferable that the transparent conductive layer 12 contain FTO since FTO exhibits high heat resistance and chemical resistance in a case in which the transparent conductive layer 12 is constituted by a single layer. The transparent conductive layer 12 may further contain a glass frit. The thickness of the transparent conductive layer 12 may be set into the range of from 0.01 to 2 µm, for example.

The width W of the groove 90 is not particularly limited, but the width of the groove is preferably 400 µm or less (refer to Fig. 4). In this case, it is possible to save extra space as compared with a case where the width W of the groove 90 is more than 400 µm. The width W of the groove 90 is preferably 250 µm or less, more preferably 220 µm or less, and still more preferably 200 µm or less.

In addition, the width W of the groove 90 is preferably 40 µm or more. In this case, as compared with a case where the width W of the groove 90 is less than 40 µm, it is possible to further improve the insulation between the adjacent transparent conductive layers 12. The width W of the groove 90 is more preferably 60 µm or more, and more preferably 80 µm or more.

The conductive film 92 is made of the same material as the transparent conductive layer 12.

The maximum thickness of the conductive film 92 is not particularly limited, but the maximum thickness is preferably 150 nm or less. In this case, as compared with a case where the maximum thickness of the conductive film 92 is more than 150 nm, the resistance between the two adjacent transparent conductive layers 12 is reduced, so that it is possible to further improve the photoelectric conversion characteristics of the photoelectric conversion element 100. The maximum thickness of the conductive film 92 is preferably 100 nm or less, and more preferably 70 nm or less. However, the maximum thickness of the conductive film 92 is preferably 30 nm or more, and more preferably 50 nm or more.

Although the cracks 91 having a length of 5 µm or more along the longitudinal direction of the groove 90 between the plurality of transparent conductive layers 12 may exist in the conductive film 92 provided on the transparent substrate 11 at a ratio of 15 or more per 100 µm in length along the longitudinal direction of the groove 90, it is preferable that the cracks 91 having a length of 5 µm or more exist in the conductive film 92 at a ratio of 20 or more per 100 µm in length along the longitudinal direction of the groove 90. In this case, it is possible to further improve the photoelectric conversion characteristics of the photoelectric conversion element 100. It is preferable that the cracks 91 having a length of 5 µm or more exist in the conductive film 92 at a ratio of 34 or more per 100 µm in length along the longitudinal direction of the groove 90. In this case, it is possible to further improve the photoelectric conversion characteristics of the photoelectric conversion element.

However, it is preferable that the cracks 91 exist in the conductive film 92 at a ratio of 200 or less per 100 µm in length along the longitudinal direction of the groove 90. In this case, the transparency of the groove 90 becomes high as compared with a case where the cracks 91 exist in the conductive film 92 at a ratio of more than 200 per 100 µm in length along the longitudinal direction of the groove 90. The cracks 91 exist more preferably at a ratio of 100 or less per 100 µm in length along the longitudinal direction of the groove 90, still more preferably at a ratio of 50 or less per 100 µm in length along the longitudinal direction of the groove 90, and particularly preferably at a ratio of 40 or less per 100 µm in length along the longitudinal direction of the groove 90.

As illustrated in Fig. 5, the bottom B of the cracks 91 may or may not reach the interface S between the transparent substrate 11 and the conductive film 92, but the bottom B of the cracks preferably reaches the interface S. In this case, since the conductive path is cut in the length direction of the cracks 91, the resistance of the conductive film 92 can be further increased.

In the photoelectric conversion element 100, it is preferable that, in a case where the bottom B of the cracks 91 reaches the interface S, the maximum thickness of the conductive film 92 be 150 nm or less, and the width W of the groove 90 be 200 nm or less.

In this case, since the conductive path in the conductive film 92 is effectively cut by the cracks 91, the insulation between the transparent conductive layers 12 can be effectively secured. As a result, it is possible to effectively improve the photoelectric conversion characteristics of the photoelectric conversion element 100.

Herein, the maximum thickness of the conductive film 92 is preferably 100 nm or less, and more preferably 70 nm or less. However, the maximum thickness of the conductive film 92 is preferably 30 nm or more, and more preferably 50 nm or more.

In addition, the width W of the groove 90 is preferably 40 µm or more. In this case, as compared with a case where the width W of the groove 90 is less than 40 µm, the insulation between the adjacent transparent conductive layers 12 is further improved. The width W of the groove 90 is more preferably 60 µm or more, and still more preferably 80 µm or more.

It is preferable that the bottom B of the cracks 91 reach a position farther from the conductive film 92 than the interface S in the transparent substrate 11. In this case, since the conductive path is cut more reliably in the length direction of the cracks 91, the resistance of the conductive film 92 can be further increased.

The connecting terminal 16 contains a metallic material. Examples of the metallic material include silver, copper and indium. These may be used singly or in combination of two or more kinds thereof.

In addition, the connecting terminal 16 may be constituted by the same material as or a different material from the conductive material 60P but it is preferable to be constituted by the same material.

In this case, it is possible to more sufficiently improve the adhesive property between the connecting terminal 16 and the conductive material 60P since the connecting terminal 16 and the conductive material 60P are constituted by the same material. For this reason, it is possible to more improve the connection reliability of the photoelectric conversion element 100.

### <Oxide semiconductor layer>

The oxide semiconductor layer 13 is constituted by oxide semiconductor particles. Such an oxide semiconductor particle is constituted by, for example, titanium oxide (TiO₂), silicon oxide (SiO₂), zinc oxide (ZnO), tungsten oxide (WO₃), niobium oxide (Nb₂O₅), strontium titanate (SrTiO₃) or tin oxide (SnO₂).

### (Insulating Material)

As the insulating material 33, an inorganic insulating material or an organic insulating material may be used. Among them, the inorganic insulating material is preferable as the insulating material 33. In this case, since the inorganic insulating material is hardly deteriorated as compared with the organic insulating material, it is possible to further improve the durability of the photoelectric conversion element 100.

As the inorganic insulating material, for example, glass frit or the like may be used.

As the organic insulating material, for example, a thermosetting resin such as a polyimide resin or a thermoplastic resin may be used.

### (Coupling portion)

The material constituting the coupling portion 14 is not particularly limited as long as it can make the back sheet 80 adhere to the transparent conductive layer 12, and it is possible to use, for example, a glass frit, a resin material which is the same as the resin material used for the sealing portion 31A, or the like as the material constituting the coupling portion 14. Among them, the coupling portion 14 is preferably a glass frit. It is possible to effectively suppress the penetration of moisture or the like from the outside of the back sheet 80 since the glass frit exhibits higher sealing ability than the resin material.

### (Dye)

As the dye, for example, a photosensitizing dye such as a ruthenium complex having a ligand including a bipyridine structure, a terpyridine structure, or the like, an organic dye such as porphyrin, eosin, rhodamine, or merocyanine; and an organic- inorganic composite dye such as a halogenated lead-based perovskite crystal may be exemplified. As the halogenated lead-based perovskite crystal, for example, CH₃NH₃PbX₃ (X = Cl, Br, I) is used. Among the above-mentioned dyes, a photosensitizing dye configured by the ruthenium complex having a ligand including a bipyridine structure or a terpyridine structure is preferred. In this case, it is possible to more improve the photoelectric conversion characteristic of the photoelectric conversion element 100. Meanwhile, in a case where a photosensitizing dye is used as the dye, the photoelectric conversion element 100 becomes a dye-sensitized photoelectric conversion element.

### (Counter substrate)

As described above, the counter substrate 20 comprises the metal substrate 21 and a conductive catalyst layer 22 which is provided on the side of the metal substrate 21 facing the conductive substrate 15 and promotes the reduction reaction on the surface of the counter substrate 20.

The metal substrate 21 is constituted by, for example, a corrosion-resistant metallic material such as titanium, nickel, platinum, molybdenum, tungsten, aluminum, stainless steel or the like. The thickness of the metal substrate 21 is appropriately determined depending on the size of the photoelectric conversion element 100 and is not particularly limited, but it may be set to from 0.005 to 0.1 mm, for example.

The catalytic layer 22 is constituted by platinum, a carbon-based material, a conductive polymer, or the like. Herein, a carbon nanotube is preferably used as the carbon-based material.

### (Sealing portion)

The sealing portion 30A is constituted by the first sealing portion 31A and the second sealing portion 32A.

Examples of the material constituting the first sealing portion 31A include a resin such as a modified polyolefin resin including an ionomer, an ethylene-vinyl acetic anhydride copolymer, an ethylene-methacrylic acid copolymer, an ethylene-vinyl alcohol copolymer and the like, an ultraviolet-cured resin, and a vinyl alcohol polymer.

The thickness of the first sealing portion 31A is typically from 20 to 90 µm and preferably from 40 to 80 µm.

Examples of the material constituting the second sealing portion 32A include a resin such as a modified polyolefin resin including an ionomer, an ethylene-vinyl acetic anhydride copolymer, an ethylene-methacrylic acid copolymer, an ethylene-vinyl alcohol copolymer and the like, an ultraviolet-cured resin, and a vinyl alcohol polymer in the same manner as the first sealing portion 31A. The material constituting the second sealing portion 32A may be the same as or different from the material constituting the first sealing portion 31A, but it is preferably the same material. In this case, the infiltration of moisture from the outside and the leakage of the electrolyte 40 can effectively be suppressed since there is no interface between the second sealing portion 32A and the first sealing portion 31A.

The thickness of the second sealing portion 32A is typically from 20 to 45 µm and preferably from 30 to 40 µm.

### (Electrolyte)

The electrolyte 40 contains, a redox couple and an organic solvent, for example. It is possible to use acetonitrile, methoxy acetonitrile, methoxy propionitrile, propionitrile, ethylene carbonate, propylene carbonate, diethyl carbonate, γ-butyrolactone, valeronitrile as the organic solvent. Examples of the redox couple include a redox couple such as a zinc complex, an iron complex, and a cobalt complex in addition to a redox couple containing a halogen atom such as iodide ion/polyiodide ion (for example, I⁻/I₃⁻), bromine ion/polybromide ion or the like. Meanwhile, iodine ion/polyiodide ion can be formed by iodine (I₂) and a salt (an ionic liquid or a solid salt) containing iodide (I⁻) as an anion. In a case of using the ionic liquid having iodide as an anion, only iodide may be added. In a case of using an organic solvent or an ionic liquid other than iodide as an anion, a salt containing iodide (I⁻) as an anion such as LiI, tetrabutylammonium iodide or the like may be added.

The electrolyte 40 may use an ionic liquid instead of the organic solvent. As the ionic liquid, for example, an ordinary temperature molten salt which is a known iodine salt, such as a pyridinium salt, an imidazolium salt, or a triazolium salt, and which is in a molten state at around room temperature is used. As such an ordinary temperature molten salt, for example, 1-hexyl-3-methylimidazolium iodide, 1-ethyl-3-propylimidazolium iodide, 1-ethyl-3-methylimidazolium iodide, 1,2-dimethyl-3-propylimidazolium iodide, 1-butyl-3-methylimidazolium iodide, or 1-methyl-3-propylimidazolium iodide is preferably used.

In addition, the electrolyte 40 may use a mixture of the above ionic liquid and the above organic solvent instead of the above organic solvent.

In addition, it is possible to add an additive to the electrolyte 40. Examples of the additive include LiI, tetrabutylammonium iodide, 4-t-butylpyridine, guanidium thiocyanate, 1-methylbenzimidazole, and 1-butylbenzimidazole.

Moreover, as the electrolyte 40, a nanocomposite gel electrolyte which is a quasi-solid electrolyte obtained by kneading nanoparticles such as SiO₂, TiO₂, and carbon nanotubes with the above electrolyte to form a gel-like form may be used, or an electrolyte gelled using an organic gelling agent such as polyvinylidene fluoride, a polyethylene oxide derivative, and an amino acid derivative may also be used.

Meanwhile, the electrolyte 40 contains a redox couple including iodide ions/polyiodide ions (for example, I⁻/I₃⁻), and a concentration of the polyiodide ions (for example, I₃⁻) is preferably 0.010 mol/L or less, more preferably 0.005 mol/L or less, and even more preferably in a range of 0 to 2×10⁻⁴ mol/L. In this case, since the concentration of mol/L or less for carrying electrons is low, leakage current can be further reduced. For this reason, an open circuit voltage can be further increased, and thus the photoelectric conversion characteristics can be further improved.

### <Conductive material>

As the conductive materials 60P and 60Q, for example, a metal film is used. It is possible to use, for example, silver or copper as the metallic material constituting the metal film.

### <Back sheet>

As described above, the back sheet 80 includes the stacked body 80A including the weather resistant layer and the metal layer and the adhesive portion 80B which is provided on the surface of the photoelectric conversion cell 50 side of the stacked body 80A and adheres the stacked body 80A and the coupling portion 14.

The weather resistant layer may be constituted by, for example, polyethylene terephthalate or polybutylene terephthalate.

The thickness of the weather resistant layer may be from 50 to 300 µm, for example.

The metal layer may be constituted by, for example, a metallic material containing aluminum. The metallic material is typically constituted by aluminum simple substance but may be an alloy of aluminum and other metals. Examples of the other metals include, for example, copper, manganese, zinc, magnesium, lead, and bismuth. Specifically, a 1000 series aluminum is desirable in which other metals are added to pure aluminum of 98% or higher purity in a trace quantity. This is because this 1000 series aluminum is inexpensive and excellent in workability compared to other aluminum alloys.

The thickness of the metal layer is not particularly limited but may be from 12 to 30 µm, for example.

The stacked body 80A may further include a resin layer. Examples of the material constituting the resin layer include a butyl rubber, a nitrile rubber, and a thermoplastic resin. These can be used singly or in combination of two or more kinds thereof. The resin layer may be formed on the entire surface on the side opposite to the weather resistant layer of the metal layer or may be formed only on the peripheral portion thereof.

Examples of the material constituting the adhesive portion 80B include a butyl rubber, a nitrile rubber, and a thermoplastic resin. These can be used singly or in combination of two or more kinds thereof. The thickness of the adhesive portion 80B is not particularly limited but may be from 300 to 1000 µm, for example.

### <Desiccant>

The desiccant 95 may be in a sheet shape or granular. The desiccant 95 may be one which absorbs moisture, for example, and examples of the desiccant 95 include silica gel, alumina, and zeolite.

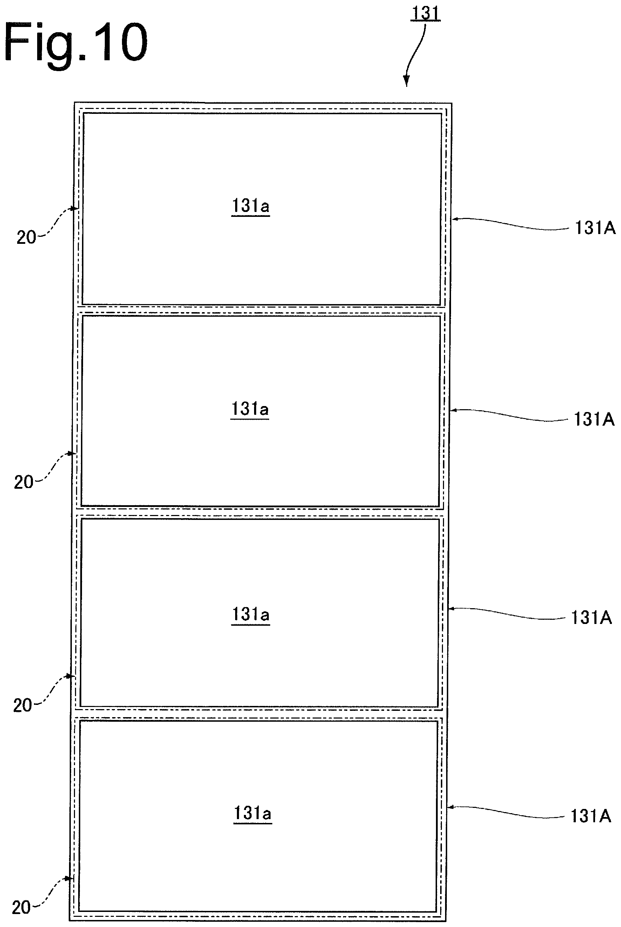

Next, the method of manufacturing the photoelectric conversion element 100 will be described with reference to Fig. 3, Fig. 9 and Fig. 10. Fig. 10 is a plan view illustrating a first integrated sealing portion forming body for forming a first integrated sealing portion of Fig. 6.

First, a laminate obtained by forming a transparent conductive film on one transparent substrate 11 is prepared.

As the method of forming the transparent conductive film, a sputtering method, a vapor deposition method, a spray pyrolysis deposition method (SPD), or a CVD method is used.

Next, as illustrated in Fig. 3, the groove 90 is formed with respect to the transparent conductive film, and the transparent conductive layers 12A to 12F which are disposed in an insulated state to interpose the groove 90 between one another are formed. Specifically, the four transparent conductive layers 12A to 12D corresponding to the photoelectric conversion cells 50A to 50D are formed so as to have the quadrangular-shaped main body portion 12a and the protruding portion 12c. At this time, the transparent conductive layers 12A to 12C corresponding to the photoelectric conversion cells 50A to 50C are formed such that the protruding portion 12c has not only the projecting portion 12d but also the facing portion 12e which extends from the projecting portion 12d and faces the main body portion 12a of the adjacent photoelectric conversion cell 50. In addition, the transparent conductive layer 12D is formed so as to have not only the quadrangular-shaped main body portion 12a and the projecting portion 12d but also the first current extracting portion 12f and the connecting portion 12g connecting the first current extracting portion 12f and the main body portion 12a. At this time, the first current extracting portion 12f is formed so as to be disposed on the side opposite to the transparent conductive layer 12B with respect to the transparent conductive layer 12A. Moreover, the transparent conductive layer 12E is formed so as to form the second current extracting portion 12h. At this time, the second current extracting portion 12h is formed so as to be disposed on the side opposite to the transparent conductive layer 12B with respect to the transparent conductive layer 12A and to be disposed next to the first current extracting portion 12f via the groove 90.

The groove 90 is formed by a laser scribing method using, for example, a fiber laser as a light source.

In the groove 90, the conductive film 92 is provided on the transparent substrate 11, but in order that the cracks 91 having a length of 5 µm or more exist in the conductive film 92 at a ratio of 15 cracks/100 µm or more by generating the cracks 91, rapid cooling of the portion of the groove 90 may be performed after forming the groove 90. The rapid cooling of the portion of the groove 90 is performed for the following reason. Namely, in a case where the groove 90 is formed by irradiating the transparent conductive film with a laser beam having high energy such as a fiber laser, the irradiated portion of the transparent conductive film has a high temperature and is melted. At this time, if the conductive material melted at the irradiated portion remains on the transparent substrate 11 in the groove 90, the temperature of the conductive material is gradually decreased to solidify the conductive material, and the conductive film 92 which is a thin conductive residual film is formed. Thereafter, if the conductive film 92 in the groove 90 is rapidly cooled, the thin conductive film 92 is thermally contracted after the forming of the groove 90, so that the cracks 91 occur in the conductive film 92. Since the conductive path between the transparent conductive layers 12 is sufficiently cut by the cracks 91, the short circuit between the transparent conductive layers 12 is sufficiently suppressed.

Specifically, the rapid cooling can be realized by blowing a compressed air into the groove 90, immersing the conductive film 92 in the groove 90 in water, or the like.

Herein, since a cooling speed of the rapid cooling can be easily adjusted, the rapid cooling is preferably performed by blowing the compressed air. In this case, the pressure of the compressed air may be, for example, in a range of 0.1 to 0.8 MPa.

In this manner, the plurality of transparent conductive layers 12A to 12F are formed on the transparent substrate 11 to obtain the conductive substrate 15.

Next, precursors of the connecting terminal 16 constituted by the conductive material connecting portion 16A and the conductive material non-connecting portion 16B are formed on the protruding portions 12c of the transparent conductive layers 12A to 12C. Specifically, the precursor of the connecting terminal 16 is formed such that the conductive material connecting portion 16A is provided on the facing portion 12e. In addition, the precursor of the connecting terminal 16 is also formed on the transparent conductive layer 12E. The precursor of the connecting terminal 16 can be formed, for example, by coating and drying a silver paste.

Moreover, a precursor of the current collecting wiring 17 is formed on the connecting portion 12g of the transparent conductive layer 12D. The precursor of the current collecting wiring 17 can be formed, for example, by coating and drying a silver paste.

In addition, precursors of the external connecting terminals 18a and 18b for extracting the current to the outside are respectively formed on the first current extracting portion 12f of the transparent conductive layer 12A and the second current extracting portion 12h. The precursor of the external connecting terminal can be formed, for example, by coating and drying a silver paste.

Furthermore, a precursor of the insulating material 33 is formed so as to enter into the first groove 90A formed along the edge portion of the main body portion 12a. The insulating material 33 can be formed, for example, by coating and drying a paste containing an insulating material such as a glass frit.

In addition, in order to fix the back sheet 80, in the same manner as the insulating material 33, a precursor of the annular coupling portion 14 is formed so as to surround the insulating material 33 and to pass through the transparent conductive layer 12D, the transparent conductive layer 12E, and the transparent conductive layer 12F.

Furthermore, a precursor of the oxide semiconductor layer 13 is formed on the main body portion 12a of each of the transparent conductive layers 12A to 12D.

The precursor of the oxide semiconductor layer 13 can be obtained by printing and then drying a paste for oxide semiconductor layer formation for forming the oxide semiconductor layer 13. The paste for oxide semiconductor layer formation contains a resin such as polyethylene glycol,ethyl cellulose or the like and a solvent such as terpineol in addition to the oxide semiconductor particles composed of titanium oxide or the like.

It is possible to use, for example, a screen printing method, a doctor blading method, or a bar coating method as the printing method of the paste for oxide semiconductor layer formation.

Finally, the precursor of the connecting terminal 16, the precursor of the insulating material 33, the precursor of the coupling portion 14, and the precursor of the oxide semiconductor layer 13 are collectively fired to form the connecting terminal 16, the insulating material 33, the coupling portion 14, and the oxide semiconductor layer 13.

At this time, the firing temperature varies depending on the kind of the oxide semiconductor particles or the insulating material 33 but is typically from 350 to 600°C, and the firing time also varies depending on the kind of the oxide semiconductor particles or the insulating material 33 but is typically from 1 to 5 hours.

In this manner, as illustrated in Fig. 9, the conductive substrate 15 is obtained on which the insulating material 33 and the coupling portion 14 for fixing the back sheet 80 are formed.

Next, the dye is supported on the oxide semiconductor layer 13. For this, the dye may be adsorbed on the oxide semiconductor layer 13 by immersing the oxide semiconductor layer 13 in a solution containing the dye, then washing out the extra dye with the solvent component of the above solution after making the dye adsorb on the oxide semiconductor layer 13, and performing drying. However, it is also possible to support the dye on the oxide semiconductor layer 13 by coating a solution containing the dye on the oxide semiconductor layer 13 and then drying to adsorb the dye on the oxide semiconductor layer 13.

Next, the electrolyte 40 is disposed on the oxide semiconductor layer 13.

Next, as illustrated in Fig. 10, a first integrated sealing portion forming body 131 for forming the first integrated sealing portion 31 is prepared. The first integrated sealing portion forming body 131 can be obtained by preparing one sheet of resin film for sealing composed of the material constituting the first integrated sealing portion 31 and forming a quadrangular-shaped opening 131a in the resin film for sealing as many as the number of the photoelectric conversion cells 50. The first integrated sealing portion forming body 131 has a structure obtained by integrating a plurality of first sealing portion forming bodies 131A.

Thereafter, this first integrated sealing portion forming body 131 is adhered on the conductive substrate 15. At this time, the first integrated sealing portion forming body 131 is adhered so as to be superimposed on the insulating material 33. The adhesion of the first integrated sealing portion forming body 131 to the conductive substrate 15 can be performed by heating and melting the first integrated sealing portion forming body 131. In addition, the first integrated sealing portion forming body 131 is adhered to the conductive substrate 15 such that the main body portion 12a of the transparent conductive layer 12 is disposed on the inner side of the first integrated sealing portion forming body 131A.

On the other hand, the counter substrates 20 are prepared to have the same number as the number of the photoelectric conversion cells 50.

The counter substrate 20 can be obtained by forming the conductive catalyst layer 22 which promotes the reduction reaction on the surface of the counter substrate 20 on the metal substrate 21.

Next, one more piece of the first integrated sealing portion forming body 131 described above is prepared. Thereafter, each of the plurality of the counter substrates 20 is bonded so as to close each of the openings 131a of the first integrated sealing portion forming body 131.

Subsequently, the first integrated sealing portion forming body 131 adhered to the counter substrate 20 and the first integrated sealing portion forming body 131 adhered to the conductive substrate 15 are superposed, and heated and melted while the first integrated sealing portion forming bodies 131 are pressed. In this way, the first integrated sealing portion 31 is formed between the conductive substrate 15 and the counter substrate 20. The first integrated sealing portion 31 may be formed under the atmospheric pressure or under reduced pressure. However, the first integrated sealing portion 31 is preferably formed under reduced pressure.

Next, the second integrated sealing portion 32 is prepared (see Fig. 7). The second integrated sealing portion 32 has a structure obtained by integrating a plurality of the first sealing portions 32A. The second integrated sealing portion 32 can be obtained by preparing one sheet of resin film for sealing and forming a quadrangular-shaped opening 32c in the resin film for sealing as many as the number of the photoelectric conversion cells 50. The second integrated sealing portion 32 is bonded to the counter substrate 20 so as to sandwich the edge portion 20a of the counter substrate 20 together with the first integrated sealing portion 31. The adhesion of the second integrated sealing portion 32 to the counter substrate 20 can be performed by heating and melting the second integrated sealing portion 32.

Examples of the resin film for sealing include a resin such as a modified polyolefin resin including ionomer, an ethylene-vinyl acetate anhydride copolymer, an ethylene methacrylic acid copolymer, an ethylene-vinyl alcohol copolymer, and the like, an ultraviolet-cured resin, and a vinyl alcohol polymer. A constituent material of the resin film for sealing for forming the second integrated sealing portion 32 preferably has a higher melting point than that of the constituent material of the resin film for sealing for forming the first integrated sealing portion 31. In this case, since the second sealing portion 32A is harder than the first sealing portion 31A, it is possible to effectively prevent contact between the counter substrates 20 of the photoelectric conversion cells 50 adjacent to each other. In addition, since the first sealing portion 31A is softer than the second sealing portion 32A, stress applied to the sealing portion 30A can be effectively relieved.

Next, the bypass diodes 70A, 70B, and 70C are fixed to the partitioning portion 32b of the second sealing portion 32. In addition, the bypass diode 70D is fixed on the sealing portion 30A of the photoelectric conversion cell 50D as well.

Thereafter, the conductive material 60Q is fixed to the metal substrate 21 of the counter substrate 20 of the photoelectric conversion cells 50B to 50D so as to pass through the bypass diodes 70A to 70D. Moreover, the conductive material 60P is formed such that each of the conductive materials 60Q between the bypass diodes 70A and 70B, between the bypass diodes 70B and 70C, and between the bypass diodes 70C and 70D is connected with the conductive material connecting portion 16A on the transparent conductive layer 12A, the conductive material connecting portion 16A on the transparent conductive layer 12B, and the conductive material connecting portion 16A on the transparent conductive layer 12C, respectively. In addition, the conductive material 60P is fixed to the metal substrate 21 of the counter substrate 20 of the photoelectric conversion cell 50A so as to connect the conductive material connecting portion 16A on the transparent conductive layer 12E and the bypass diode 70A. Moreover, the transparent conductive layer 12D is connected with the bypass diode 70A by the conductive material 60P.

At this time, with regard to the conductive material 60P, a paste containing a metallic material constituting the conductive material 60P is prepared, and this paste is coated from the counter substrate 20 over the conductive material connecting portion 16A of the connecting terminal 16 of the adjacent photoelectric conversion cell 50 and cured. With regard to the conductive material 60Q, a paste containing a metallic material constituting the conductive material 60Q is prepared, and this paste is coated on each of the counter substrates 20 so as to link the adjacent bypass diodes and cured. At this time, as the above paste, it is preferable to use a low-temperature curing type paste which is capable of being cured at a temperature of 90°C or less from the viewpoint of avoiding an adverse effect on the dye.

Finally, the back sheet 80 is prepared, and the peripheral portion 80a of the back sheet 80 is adhered to the coupling portion 14. At this time, the back sheet 80 is disposed such that the adhesive portion 80B of the back sheet 80 is spaced apart from the sealing portion 30A of the photoelectric conversion cell 50.

The photoelectric conversion element 100 is obtained in the manner described above.

Meanwhile, in the description mentioned above, a method to collectively fire the precursor of the connecting terminal 16, the precursor of the insulating material 33, the precursor of the coupling portion 14, and the precursor of the oxide semiconductor layer 13 is used in order to form the connecting terminal 16, the insulating material 33, the coupling portion 14, and the oxide semiconductor layer 13, but the connecting terminal 16, the insulating material 33, the coupling portion 14, and the oxide semiconductor layer 13 may be formed by separately firing each of the precursors.

The invention is not limited to the above-described embodiment. For example, in the above-described embodiment, in the conductive film 92 in the groove 90 between the adjacent transparent conductive layers 12, the cracks 91 are in contact with the edge portion of the groove 90, that is, the transparent conductive layer 12. However, the cracks are not necessarily in contact with the edge portion of the groove 90.

In addition, in the above-described embodiment, in the conductive film 92 in the groove 90 between the adjacent transparent conductive layers 12, the cracks 91a and 91b that intersect with the other cracks 91 exist, but the cracks 91a and 91b that intersect with the other cracks 91 may not exist. Namely, the cracks 91 may be configured with only the cracks 91c and 91d that do not intersect with the other cracks 91.

In addition, in the above-described embodiments, the conductive substrate 15 has the insulating material 33. However, the conductive substrate 15 may not have the insulating material 33. In this case, the sealing portion 30A and the first integrated sealing portion 31A are directly bonded to the transparent substrate 11 and the transparent conductive layer 12.

In addition, in the above-described embodiment, the groove 90 has the second groove 90B, but the second groove 90B may not be necessarily formed.

In addition, in the above-described embodiment, the conductive material connecting portion 16A and the conductive material non-connecting portion 16B are provided along the sealing portion 30A, respectively, but these may be formed so as to extend in the direction away from the sealing portion 30A. However, in this case, it is preferable that the conductive material connecting portion 16A be disposed at the position closer to the sealing portion 30A than the conductive material non-connecting portion 16B. In this case, it is possible to more shorten the conductive material 60P. Meanwhile, the connecting terminal 16 may not be necessarily provided on the transparent conductive layer 12.

In addition, in the above-described embodiment, the second sealing portion 32A is adhered to the first sealing portion 31A, but the second sealing portion 32A may not be adhered to the first sealing portion 31A.

Furthermore, in the above-described embodiment, the sealing portion 30A is constituted by the first sealing portion 31A and the second sealing portion 32A, but the second sealing portion 32A may be omitted.

In addition, in the above-described embodiment, the back sheet 80 is adhered to the transparent conductive layer 12 via the coupling portion 14, but the back sheet 80 is not necessarily required to be adhered to the transparent conductive layer 12 via the coupling portion 14.

Furthermore, in the above-described embodiment, the coupling portion 14 and the insulating material 33 are separated from each other, but the coupling portion 14 and the insulating material 33 may be integrated.

In addition, while the photoelectric conversion element has the back seat 80 in the above embodiment, the photoelectric conversion element may not have the back seat 80.

Further, while the photoelectric conversion element 100 has the bypass diodes in the above-described embodiment, the photoelectric conversion element 100 may not necessarily have the bypass diodes.

In addition, in the above-described embodiment, the transparent conductive layer 12 is used as the conductive layer. However, in a case where the counter substrate 20 is transparent, the conductive layer is not necessarily transparent. In this case, the substrate supporting the conductive layer is not necessarily transparent.

Furthermore, in the above-described embodiment, the oxide semiconductor layer 13 is provided on the transparent conductive layer 12. However, in a case where the photoelectric conversion element 100 does not have the back sheet 80, the counter substrate 20 is transparent and conductive, the oxide semiconductor layer 13 may be provided on the counter substrate 20.

Furthermore, in the above-described embodiment, the photoelectric conversion element 100 has the plurality of photoelectric conversion cells 50. However, if the transparent conductive layer 12 is arranged on the transparent conductive layer 12 of one photoelectric conversion cell 50 through the groove 90, the photoelectric conversion element may have only one photoelectric conversion cell 50.

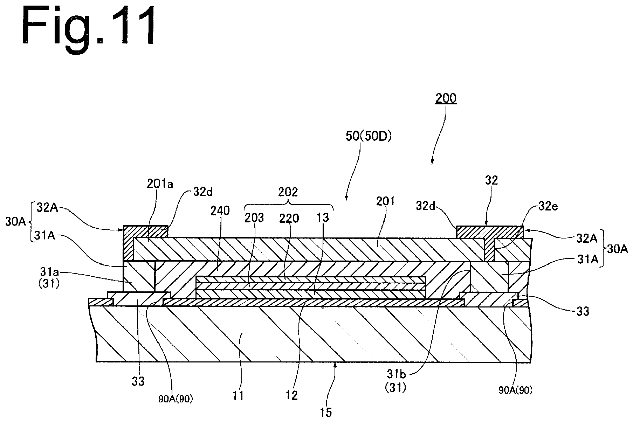

In addition, in the above-described embodiment, the counter substrate 20 is constituted by the counter electrode, but like the photoelectric conversion element 200 illustrated in Fig. 11, an insulating substrate 201 may be used instead of the counter electrode as a counter substrate 20. In this case, a structure 202 is disposed in a space between an insulating substrate 201 and the sealing portion 31. The structure 202 is provided on the surface of the side facing the insulating substrate 201 of the conductive substrate 15. The structure 202 is constituted by the oxide semiconductor layer 13, the porous insulating layer 203, and the counter electrode 220 in order from the conductive substrate 15. In addition, an electrolyte 240 is disposed in the space above. The electrolyte 240 is impregnated even into the inside of the oxide semiconductor layer 13 and the porous insulating layer 203. As the electrolyte 240, the same one as the electrolyte 40 can be used. Herein, it is possible to use, for example, a glass substrate or a resin film as the insulating substrate 201. In addition, it is possible to use the same one as the counter substrate 20 as the counter electrode 220. Alternatively, the counter electrode 220 may be constituted by, for example, a porous single layer containing carbon or the like. The porous insulating layer 203 is mainly provided in order to prevent the physical contact of the oxide semiconductor layer 13 and the counter electrode 220 and to impregnate the electrolyte 240 thereinto. It is possible to use, for example, a fired body of an oxide as such a porous insulating layer 203. Meanwhile, although in the photoelectric conversion element 200 illustrated in Fig. 11, only one of the structure 202 is provided in the space between the sealing portion 31A, the conductive substrate 15 and the insulating substrate 201, the plurality of the structures 202 may be provided. In addition, the porous insulating layer 203 is provided between the oxide semiconductor layer 13 and the counter electrode 220. However, the porous insulating layer 203 may be provided between the conductive substrate 15 and the counter electrode 220 so as to surround the oxide semiconductor layer 13 without providing the porous insulating layer between the oxide semiconductor layer 13 and the counter electrode 220. With this structure as well, physical contact of the oxide semiconductor layer 13 and the counter electrode 220 can be prevented.

### EXAMPLES

Hereinafter, the content of the invention will be described more specifically with reference to Examples, but the invention is not limited to the following Examples.

### (Example 1)

First, a laminate obtained by forming a transparent conductive film made of FTO having a thickness of 0.1 µm on a transparent substrate being made of glass and having a size of 5 cm × 10 cm × 1 mm was prepared.

Next, one linear portion crossing the center of the transparent conductive film was irradiated with a laser beam by a fiber laser (product name: "50W pulse oscillation fiber laser", produced by Fujikura Co., Ltd.) to form grooves, and two transparent conductive layer were formed. At this time, the width of the groove was set to 84 µm.

After forming the groove, rapid cooling of the bottom of the groove was performed by blowing compressed air of the pressure listed in Table 1 to the groove for 10 seconds.

Then, the resistance value between the two transparent conductive layers was measured with a tester. The results are listed in Table 1. However, in Table 1, the resistance value of Example 1 was set as a relative value when the resistance value between the two transparent conductive layers in Comparative Example 1 was set to 1. Furthermore, the 10 regions having a length of 100 µm along the longitudinal direction of the grooves were observed by using a SEM, and in each region, the number of cracks having a length of 5 µm or more existing per 100 µm in length along the longitudinal direction of the grooves was counted. The average value of the number of cracks in the 10 regions was obtained. The results are listed in Table 1. In addition, intersecting cracks existed in the grooves between the transparent conductive layers. Furthermore, the 10 regions having a length of 100 µm along the longitudinal direction of the grooves were observed with a TEM. As a result, it was found that a conductive film (conductive residue) was provided on the transparent substrate in all the 10 regions, and cracks existed in the conductive film. Furthermore, the maximum thickness of the conductive film was obtained in each region, and the average value thereof was obtained. The results are listed in Table 1. Furthermore, when cross sections of the conductive film and the transparent substrate were observed with the TEM in all 10 regions, all the cracks existing in the conductive film reached the interface between the transparent substrate and the conductive film.

Next, a precursor of the oxide semiconductor layer 13 was formed on each of the two transparent conductive layers. By printing a titanium oxide nano paste on a region having a size of 1 cm × 1 cm on the surface of the transparent conductive layer with respect to the precursor of the oxide semiconductor layer 13 and then firing the precursor of the oxide semiconductor layer 13, an oxide semiconductor layer made of a porous titanium oxide film having a thickness of 10 µm was obtained.

By immersing the obtained laminate in a Z907 dye solution, a Z907 dye was adsorbed to the oxide semiconductor layer. At this time, as a solvent in the dye solution, a mixed solvent of t-butanol and acetonitrile was used. Then, an annular sealing portion having a thickness of 50 µm and being made of maleic anhydride modified polyethylene (product name: Bynel, produced by Du Pont) was arranged so as to surround the oxide semiconductor layer formed on each of the two transparent conductive layers.

Next, an electrolyte was applied on the oxide semiconductor layer.

On the other hand, a glass provided with a conductive film obtained by sputtering platinum on a glass substrate and having a size of 5 cm × 5 cm × 1 mm was prepared as a counter electrode.

Then, the counter electrode was arranged so as to face the oxide semiconductor layer, and the sealing portion was heated and melted to connect the transparent conductive layer and the counter electrode. Thus, a photoelectric conversion element composed of two dye-sensitized solar cells was obtained.

### (Examples 2 to 8)

Photoelectric conversion elements were manufactured in the same manner as in Example 1 except that the number of the cracks having a length of 5 µm or more existing per 100 µm in length along the longitudinal direction of the grooves was set to the value listed in Table 1 and the width of the groove and the maximum thickness of the conductive film were the values listed in Table 1 by setting the pressure of the compressed air at the time of rapid cooling after formation of the grooves in the transparent conductive film to the values listed in Table 1. Meanwhile, in the photoelectric conversion elements of Examples 2 to 8, it was found that intersecting cracks existed in the grooves between the transparent conductive layers. In addition, in the photoelectric conversion elements of Examples 2 to 8, as a result of TEM observation of 10 regions having a length of 100 µm along the longitudinal direction of the grooves, it was found that, in all the 10 regions, the conductive film (conductive residue) was provided on the transparent substrate, and cracks existed in the conductive film. In addition, it was also found that intersecting cracks existed in the conductive film. Furthermore, it was found that, when cross sections of the conductive film and the transparent substrate were observed with the TEM in all 10 regions having a length of 100 µm along the longitudinal direction of the groove, it was found that all the cracks existing in the conductive film reached the interface between the transparent substrate and the conductive film. Furthermore, when manufacturing the photoelectric conversion elements of Examples 2 to 8, the resistance values between the two transparent conductive layers were measured in the same manner as in Example 1, and the relative values when the resistance value between the two transparent conductive layers in Comparative Example 1 was set to 1 were calculated. The results are listed in Table 1.

### (Comparative Example 1)

A photoelectric conversion element was manufactured in the same manner as in Example 1 except that the number of cracks having a length of 5 µm or more existing per 100 µm in length along the longitudinal direction of the groove was set to the value listed in Table 1, and the width of the groove and the maximum thickness of the conductive film were set to values listed in Table 1 by not blowing a compressed air at the time of rapid cooling after formation of the grooves in the transparent conductive film. Meanwhile, in the photoelectric conversion element of Comparative Example 1, as a result of TEM observation of 10 regions having a length of 100 µm along the longitudinal direction of the grooves, it was found that, in all the 10 regions, a conductive film (conductive residue) was provided on the transparent substrate, and cracks existed in the conductive film. In addition, it was also found that no intersecting cracks existed in the conductive film. Furthermore, it was found that, when cross sections of the conductive film and the transparent substrate were observed with the TEM in all 10 regions having a length of 100 µm along the longitudinal direction of the groove, all the cracks existing in the conductive film reached the interface between the transparent substrate and the conductive film. Furthermore, when manufacturing the photoelectric conversion element of Comparative Example 1, the resistance value between the two transparent conductive layers was measured in the same manner as in Example 1, and the relative value when the resistance value between the two transparent conductive layers in Comparative Example 1 was set to 1 was calculated. The results are listed in Table 1.

### (Comparative Examples 2 and 3)

Photoelectric conversion elements were manufactured in the same manner as in Example 1 except that the number of the cracks having a length of 5 µm or more existing per 100 µm in length along the longitudinal direction of the groove was set to the value listed in Table 1, and the width of the groove and the maximum thickness of the conductive film were set to the values listed in Table 1 by setting the pressure of the compressed air at the time of rapid cooling after formation of the grooves in the transparent conductive film to the values listed in Table 1. Meanwhile, in the photoelectric conversion elements of Comparative Examples 2 and 3, as a result of TEM observation of 10 regions having a length of 100 µm along the longitudinal direction of the grooves, it was found that, in all the 10 regions, a conductive film (conductive residue) was provided on the transparent substrate, and cracks existed in the conductive film. In addition, it was also found that no intersecting cracks existed in the conductive film. Furthermore, it was found that, when cross sections of the conductive film and the transparent substrate were observed with the TEM in all 10 regions having a length of 100 µm along the longitudinal direction of the groove, all the cracks existing in the conductive film reached the interface between the transparent substrate and the conductive film. Furthermore, when manufacturing the photoelectric conversion elements of Comparative Examples 2 and 3, the resistance values between the two transparent conductive layers were measured in the same manner as in Example 1, and the relative values when the resistance value between the two transparent conductive layers in Comparative Example 1 was set to 1 were calculated. The results are listed in Table 1.

The two dye-sensitized solar cells of Examples 1 to 8 and Comparative Examples 1 to 3 thus obtained were connected in series, IV measurement was performed under illuminance of 1000 lux by using a white LED as a light source, and thus, the photoelectric conversion efficiency η was obtained. The results are listed in Table 1.

**[Table 1]**

| | Maximum thickness of conductive residue (µm) | Width of groove (mm) | Pressure of compressed air (MPa) | Resistance value (Resistance value in Comparative Example 1 is set to 1) | Number of cracks having length of 5 µm or more (cracks/100 µm) | Photoelectric conversion efficiency η (%) |
|---|---|---|---|---|---|---|
| Example 1 | 74 | 84 | 0.1 | 244 | 17 | 9.6 |
| Example 2 | 72 | 84 | 0.2 | 250 | 24 | 9.6 |
| Example 3 | 72 | 84 | 0.4 | 255 | 29 | 9.7 |
| Example 4 | 70 | 84 | 0.6 | 258 | 34 | 9.8 |
| Example 5 | 67 | 84 | 0.8 | 276 | 37 | 9.8 |
| Example 6 | 64 | 120 | 0.8 | 282 | 38 | 9.8 |
| Example 7 | 65 | 150 | 0.8 | 276 | 38 | 9.8 |
| Example 8 | 64 | 200 | 0.8 | 270 | 35 | 9.8 |
| Comparative Example 1 | 77 | 84 | - | 1 | 3 | 5.4 |
| Comparative Example 2 | 77 | 84 | 0.01 | 2 | 6 | 5.6 |
| Comparative Example 3 | 74 | 84 | 0.05 | 60 | 10 | 7.3 |

As listed in Table 1, it was found that, in the photoelectric conversion elements of Examples 1 to 8, as compared with the photoelectric conversion elements of Comparative Examples 1 to 3, the resistance value between the two transparent conductive layers remarkably increased and the photoelectric conversion efficiency increased.

From the above results, it was found that the photoelectric conversion characteristics of the photoelectric conversion element of the invention can be sufficiently improved.

### EXPLANATIONS OF LETTERS OR NUMERALS

- 11: transparent substrate (substrate)
- 12: transparent conductive layer (conductive layer)
- 13: oxide semiconductor layer
- 15: conductive substrate
- 20: counter substrate
- 50, 50A to 50D: photoelectric conversion cell
- 90: groove
- 91: crack
- 92: conductive film
- 100, 200: photoelectric conversion element
- B: bottom of crack
- W: width of groove

## Claims

1. A photoelectric conversion element having a substrate; and a plurality of conductive layers provided on the substrate and arranged with grooves interposed therebetween, comprising:
at least one photoelectric conversion cell,
wherein the photoelectric conversion cell includes:
one conductive layer of the plurality of conductive layers;
a counter substrate facing the conductive layer; and
an oxide semiconductor layer provided between the conductive layer and the counter substrate, and
wherein a conductive film is provided on the substrate along a longitudinal direction of the grooves between the plurality of conductive layers, and cracks having a length of 5 µm or more exist in the conductive film at a ratio of 15 or more per 100 µm in length along the longitudinal direction of the groove.

2. The photoelectric conversion element according to claim 1, wherein the conductive film is made of the same material as the conductive layer.

3. The photoelectric conversion element according to claim 1 or 2, wherein the cracks having a length of 5 µm or more exist in the conductive film at a ratio of 200 or less per 100 µm in length along the longitudinal direction of the groove.

4. The photoelectric conversion element according to claim 3, wherein the cracks having a length of 5 µm or more exist in the conductive film at a ratio of 40 or less per 100 µm in length along the longitudinal direction of the groove.

5. The photoelectric conversion element according to any one of claims 1 to 4, wherein the cracks having a length of 5 µm or more exist in the conductive film at a ratio of 34 or more per 100 µm in length along the longitudinal direction of the groove.

6. The photoelectric conversion element according to any one of claims 1 to 5, wherein cracks intersecting each other exist in the conductive film.

7. The photoelectric conversion element according to any one of claims 1 to 6, wherein the grooves between the plurality of conductive layers are covered with an insulating material.

8. The photoelectric conversion element according to any one of claims 1 to 7,
wherein a maximum thickness of the conductive film is 150 nm or less,
wherein a width of the groove is 200 nm or less, and wherein a bottom of the cracks reaches an interface between the substrate and the conductive film.

9. The photoelectric conversion element according to any one of claims 1 to 7, wherein a bottom of the cracks reaches a position farther from the conductive film than an interface between the substrate and the conductive film in the substrate.

10. The photoelectric conversion element according to any one of claims 1 to 9, wherein the cracks are in contact with the conductive layer.
